# EUROPEAN PATENT SPECIFICATION

(11) **EP 2 610 389 B1**
(45) Date of publication and mention of the grant of the patent: **25.06.2014**
(21) Application number: 11196057.1
(22) Date of filing: 29.12.2011
(51) Int. Cl.: D06F 39/00, H05K 5/00

(54) **Electric appliance with control-panel assembly**
Elektrisches Gerät mit Steuertafelanordnung
Appareil électrique avec ensemble de panneau de commande

(43) Date of publication of application: 03.07.2013
(73) Proprietor: Electrolux Home Products Corporation N.V., 1130 Brussel (BE)
(72) Inventor: Marcuz, Rodolfo, 33080 PORCIA (IT); Bas, Alberto, 33080 Porcia (IT); Morandini, Stefano, 33080 Porcia (IT); De Pellegrin, Andrea, 33080 Porcia (IT); De Luca, Fernando, 33080 Porcia (IT)
(74) Representative: Maccalli, Marco

(56) References cited:
- WO-A1-2011/144484
- DE-U1- 20 210 707
- US-A1- 2005 210 926
- US-B1- 6 356 321

## Description

### Field of the invention

The present invention generally relates to electric appliances, such as front/top loading washing machines, washers/dryers, dryers, dishwashers, refrigerators, ovens, both for domestic and professional use. More particularly, the present invention relates to a control-panel assembly for such electric appliances.

### Background of the invention

Each household and professional electric appliance (hereinafter, appliance, for the sake of conciseness) - such as washing machine, washer/dryer, dryer, dishwasher, refrigerator, oven - typically comprises a substantially parallepiped-shaped cabinet enclosing an inner compartment for housing items to be treated (*e.g*., washed and/or dried, refrigerated, heated), an access door for accessing the inner compartment thereby allowing loading/unloading operations of the items by a user, and a manually-operable dashboard (typically including control members, *e.g*., rotatable knobs, display devices, buttons, switches and the like) for allowing the user to manually control operation of the appliance and ascertain an operational state thereof.

As known, the dashboard represents an exposed part of a control-panel assembly, which typically comprises an inner printed circuit board (or PCB) that is electrically connected to electronic components and the control members associated therewith for implementing corresponding control functionalities, *e.g*. powering, driving, activation, deactivation of operative loads including electric, electronic, electro-mechanical and/or electro-hydraulic parts of the appliance (such as motor, solenoid valve, further PCBs and the like).

In order to achieve that, the PCB is typically coupled with the operative loads to be controlled by means of one ore more electrical connectors (in the following, connectors). Each connector, properly mounted on the PCB, is configured for contacting respective electrical terminals (or terminals) of the electronic components on the PCB, and for mechanically and electrically joining electric wires, pins, and the like (in the following referred to as connection elements) from one or more of the operative loads which the PCB has to be connected to.

As known, many design efforts by appliances manufacturers are directed to provide firm and easy mounting of the connectors, as well as ensure accessibility thereof for proper connection of the PCB with the operative loads.

In fact, providing firm and easy mounting of the connectors on the PCB avoids vibrations and/or any other mechanical stress to the control-panel assembly, *e.g*. due to operation of the appliance or to transport thereof, from causing accidental detaching of the connectors from the PCB (which would preclude the control of the appliance operation by the user), whereas accessibility of the connectors ensures easy connection of the PCB with the operative loads, both during appliance manufacturing and after it (*e.g*., during repair and/or maintenance operations of the appliance). In fact, in the latter case, a not firm connection of the connectors makes repair or maintenance operations difficult, as the repairman or the maintenance man has to pay close attention not to touch the PCB, the connectors and the connection elements more than his/her due in order to not cause accidental damages to the control-panel assembly, whereas a not easy accessibility to the connectors makes the repair or maintenance operations complex, hence prone to errors, and longer, thus disadvantageous in terms of costs.

In many of the control-panel assemblies which the currently marketed appliances are provided with, connectors are straddle-mounted to corresponding edge portions of the PCB at which the electrical terminals are arranged, and fixed/held to the PCB by a conventional fixing technique (*e.g*., gluing, soldering and the like). Instead, as far as accessibility of the connectors is concerned, such requirement substantially opposes, and typically is subordinated to the need of ensuring adequate mechanical protection to the connectors (as well as to the electronic components on the PCB); in fact, in today appliances the whole PCB (including connectors already mounted thereon) is typically enclosed by a protecting case member (*e.g*. in the form of two half-cases configured for being coupled with each other), and accessibility of the connectors is typically achieved by openings formed on portions of the case member at the connectors.

A related art is disclosed in patent application publication US 2005/0210926 A1.

### Summary of invention

The Applicant has realized that the known devised and practiced solutions are not satisfactory for modern technological requirements.

In fact, according to the Applicant, the approach providing the connectors of the straddle-mounting type fixed/held to the PCB by soldering or gluing could not be sufficiently effective and reliable, as solder and glue are easily subject to corrosions and other wearing effects over time. Moreover, the Applicant believes that such fixing techniques make the fixing operations of the connectors to the PCB not much practical and difficultly reversible.

Moreover, the Applicant has also found that the approach providing openings formed on the case member enclosing the PCB for making the connectors accessible for connection with the operative loads is not fully satisfactory. In fact, although in principle such approach would allow the connectors to be accessible from the external of the case member, the Applicant has instead verified in the field that the openings, having to be small enough to still ensure protection to the connectors (*i.e*. in order to prevent them from being excessively exposed), turn out to "bury" in the case member, and thus are of-fact made scarcely accessible by obstruction of the case member itself (thereby making connection and/or, reversibly, disconnection of the operative loads to and/or from the PCB difficult). On the other hand, making the openings larger for improving accessibility greatly reduces, or even precludes, mechanical protection thereof.

The Applicant has also recognized that the above connectors accessibility issue exacerbates as the complexity of control-panel assembly - *e.g*., in terms of number and type of control members (and electronic components, accordingly) to be connected on the PCB - increases. For example, in a wide class of last-generation appliances, such as those provided with display devices, *e.g*., one flat touch screen display (in the following, display) mounted on the PCB, the case member, having to protect the display as well, has more complex shape and larger size. Thus, the openings may also prove difficult to be formed (*e.g*., because of a particularly irregular shape of the case member), and the connectors are thus made less accessible or less protected.

Last but not least, this causes the case member to greatly influence production, warehousing and managing cost of the control-panel assembly, and hence of the appliance.

The Applicant has tackled the problem of devising a satisfactory solution able to overcome the above-discussed drawbacks.

One or more aspects of the solution according to specific embodiments of the invention are set out in the independent claims, with advantageous features of the same solution that are indicated in the dependent claims.

The solution according to one or more embodiments of the present invention relates to an electric appliance for items treatment. The electric appliance comprises a control-panel assembly for controlling operation of the electric appliance and ascertaining an operational state thereof. The control-panel assembly comprises a display assembly having a display device, and a printed circuit board having an active surface for mechanically supporting and electrically connecting the display device, and at least one electrical connector apt to be fixed to a corresponding terminal region of the printed circuit board for allowing connection thereof to one or more operative loads of the electric appliance. In the solution according to one or more embodiments of the present invention, the display assembly comprises a mounting member for holding the display device and allowing mounting of the display assembly on the active surface of the printed circuit board. The mounting member comprises at least one recessed portion for exposing the terminal region thereby allowing reversible fixing thereon of the at least one electrical connector and hence connection to one or more operative loads of the appliance.

The mounting member may advantageously comprise a substantially hollow parallelepiped-shaped support body having a first edge portion fixed to the display device for supporting it, and a second edge portion opposite the first edge portion for abutting on the active surface upon mounting of the display assembly thereon, so that the display assembly may cover at least part of the circuitry provided on the active surface of the PCB for mechanical protection thereof. The mounting member may also comprise a frame body substantially surrounding at least part of the support body, and preferably, although not necessarily, provided with the at least one recessed portion.

The at least one electrical connector may comprise at least one straddle-mounting connector. In such case, the at least one recessed portion may advantageously comprise a guiding member for guiding the at least one straddle-mounting connector to the terminal region of the printed circuit board, and a clip element mechanically connected to the guiding member and configured for snap-fitting the at least one straddle-mounting connector to the terminal region thereby enabling electrical connection thereof.

The at least one straddle-mounting connector may be configured for being mounted straddle the active surface and a rear surface of the printed circuit board opposite the active surface. In such configuration, preferably the guiding member is substantially U-shaped with a width substantially matching the width of the at least one straddle-mounting connector, and preferably protrudes, after mounting of the display assembly, beyond the rear surface of the printed circuit board for guiding the at least one straddle-mounting connector both at the active surface side and at the rear surface side thereof.

Advantageously, the frame body is further provided with at least one further recessed portion for exposing at least one of the at least one electrical connector hard-mounted on the printed circuit board thereby allowing connection thereof to one or more operative loads of the appliance. Additionally or alternatively, the frame body may comprise at least one insertion element protruding beyond the rear edge portion of the support body, and configured for being inserted into corresponding through-holes of the printed circuit board for mounting of the display assembly.

In a further embodiment, the frame body may also comprise at least one still further recessed portion configured for providing the frame body with a predefined degree of elastic deformability that allows insertion of the at least one insertion element into the corresponding through-hole of the printed circuit board upon exertion of a compression force on the frame body, and snap-fit engagement between the at least one insertion element and the corresponding through-hole upon inexertion of said compression force.

In a preferred, not limiting configuration, the display assembly comprises at least one lighting guide configured for conveying light produced by one or more lighting members arranged on the active surface of printed circuit board, and a supporting rack mechanically connected to the mounting member for supporting the at least one lighting guide.

Preferably, the supporting rack and/or the mounting member are made of plastic material, and even more preferably said plastic material comprises at least a light permeable portion.

Advantageously, the at least one lighting guide faces said one or more lighting members when the display assembly is mounted onto the printed circuit board.

The electric appliance, which may comprise (without departing from the scope of the present invention) one among front or top loading washing machine, washer/dryer, dryer, dishwasher, refrigerator, oven, is preferably provided with a manually-operable dashboard which represents an exposed part of the control-panel assembly. Said manually-operable dashboard may comprise a substantially basin-shaped rigid shell and at least one manually-operable control member (*e.g*., comprising at least one rotatable knob, at least one button, and/or the display device) engaging corresponding pass-through openings and/or seats of the shell and electrically connected to the printed circuit board.

Thanks to the present invention, the connectors are fixed and held to the PCB in a simple, effective, reliable and easily reversible way, without using techniques that could make the holding subject to corrosions and other wearing effects over time. Moreover, this has been achieved by cooperation with a new, simple member configured for making the connectors easily accessible for fully satisfactory connection with the operative loads (without precluding mechanical protection thereof), and whose general concept may be adapted to substantially any control-panel assembly, even the most complex ones (such as those provided with one or more displays).

### Brief description of the annexed drawings

The solution according to one or more embodiments of the invention, as well as further features and the advantages thereof, will be best understood with reference to the following detailed description, given purely by way of a non-restrictive indication, to be read in conjunction with the accompanying drawings (wherein corresponding elements are denoted with equal or similar references, and their explanation is not repeated for the sake of exposition brevity). In this respect, it is expressly understood that the figures are not necessarily drawn to scale (with some details that may be exaggerated and/or simplified) and that, unless otherwise indicated, they are simply used to conceptually illustrate the described structures and procedures. In particular:
**Figure 1** schematically shows a perspective view of an electric appliance wherein the solution according to one or more embodiments of the present invention may be applied;
**Figure 2** shows a perspective exploded view of a control-panel assembly according to an embodiment of the present invention;
**Figures 3A** and **3B** show perspective front views of a portion of the control-panel assembly according to an assembled configuration and to a partly-assembled configuration, respectively;
**Figures 4A** and **4B** show perspective rear views of the portion of the control-panel assembly of **Figures 3A** and **3B****,** respectively, and
**Figure 5** show a perspective view of another portion of the control-panel assembly of **Figure 2** according to another embodiment of the present invention.

### Detailed description of preferred embodiments of the invention

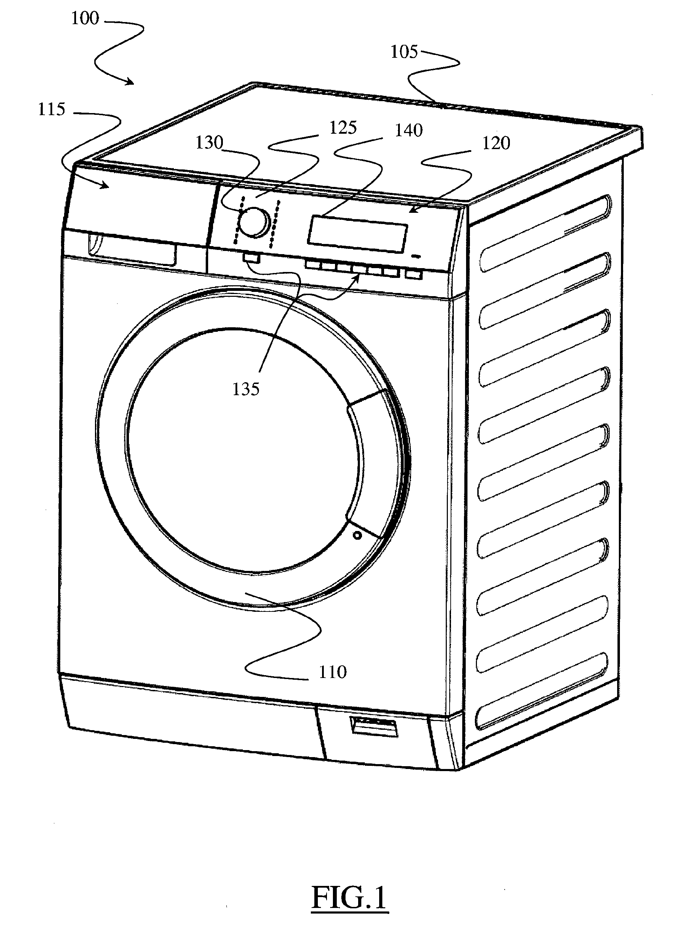

Referring now to the drawings, **Figure 1** schematically shows a perspective view of a an electric appliance (*e.g*., an electric household appliance), or appliance **100,** wherein the solution according to one or more embodiments of the present invention may be applied. As will be best understood by the following description, the teachings of the present invention may be applied to substantially any appliance for items treatment, *e.g*. laundry treatment appliances, such as washers/dryers (as exemplarily illustrated in the figure, and to which reference will be made in the following by way of a non-limiting example only), washing machines, dryers, either of the front loading type (as exemplarily depicted in the figure) or of the top loading type, as well as dishwashers, refrigerators, ovens and the like generally provided with user-interface means (*e.g*. dashboard).

The appliance **100** comprises a substantially parallepiped-shaped cabinet **105,** which encloses an inner compartment comprising a *e.g*. rotating drum (not shown) for housing the laundry to be treated (*e.g*., washed and/or dried), a tub (also not visible) encasing the drum, and an access door **110** (shown in a closed configuration) provided on a front wall of the cabinet **105** for accessing the drum thereby allowing loading/unloading operations of the laundry by a user.

Preferably, although not necessarily, the appliance **100** further comprises, *e.g*. incorporated into an upper portion of the front wall of the cabinet **105,** a compartment **115** (whose lid is only visible in the figure) fluidly connected to the inside of the tub and configured for being loaded with washing/rinsing products (*i.e*., detergent, softener, and the like).

Moreover, the appliance **100** further comprises, *e.g*. incorporated into another upper portion of the front wall of the cabinet **105,** a manually-operable dashboard **120** generally configured for allowing the user to manually control operation of the appliance **100** and ascertain an operational state thereof; as usual, the dashboard **120** represents an exposed part of a control-panel assembly (not visible in such figure), which will be better discussed in the following when disclosing embodiments of the present invention.

The dashboard **120** mainly comprises a preferably, although not necessarily, substantially basin-shaped rigid shell **125** (for example, made of plastic material) configured for engaging a corresponding opening of the cabinet **105,** and a number (*i.e*., one or more) of (exposed parts of) manually-operable control members (*e.g*., rotatable knobs, display devices, buttons, switches and the like), such as the rotatable knob **130,** the buttons **135,** and the *e.g*. flat touch screen display device **140,** all engaging corresponding pass-through openings and/or seats of the shell **125** thereby protruding and/or facing therefrom.

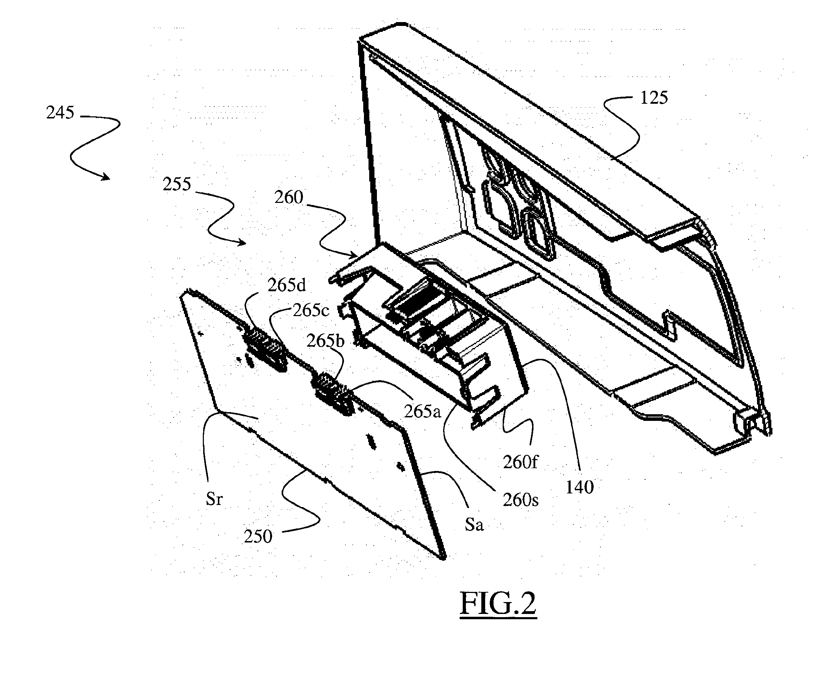

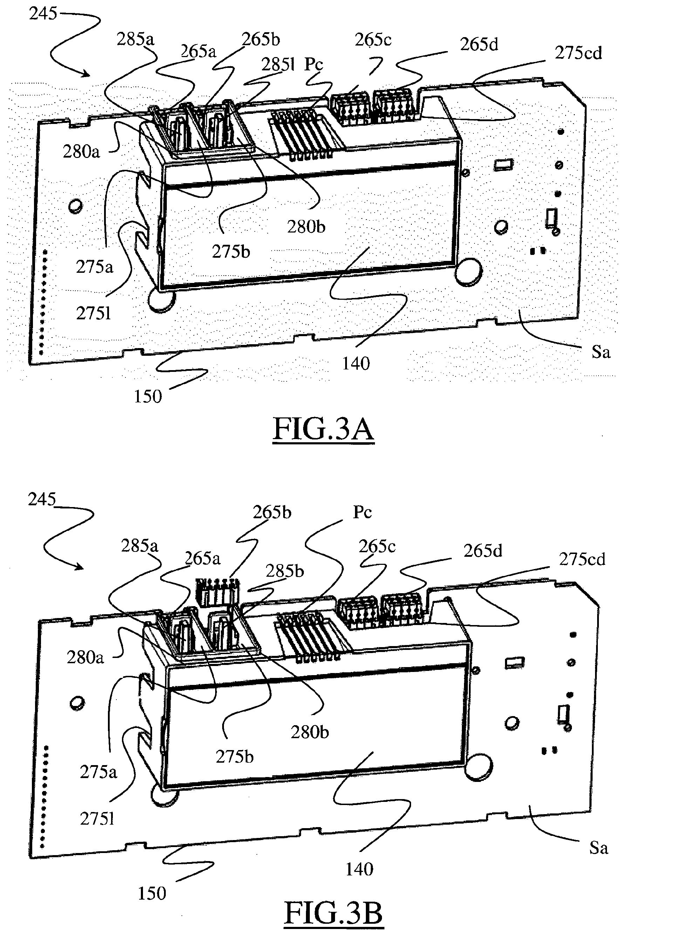

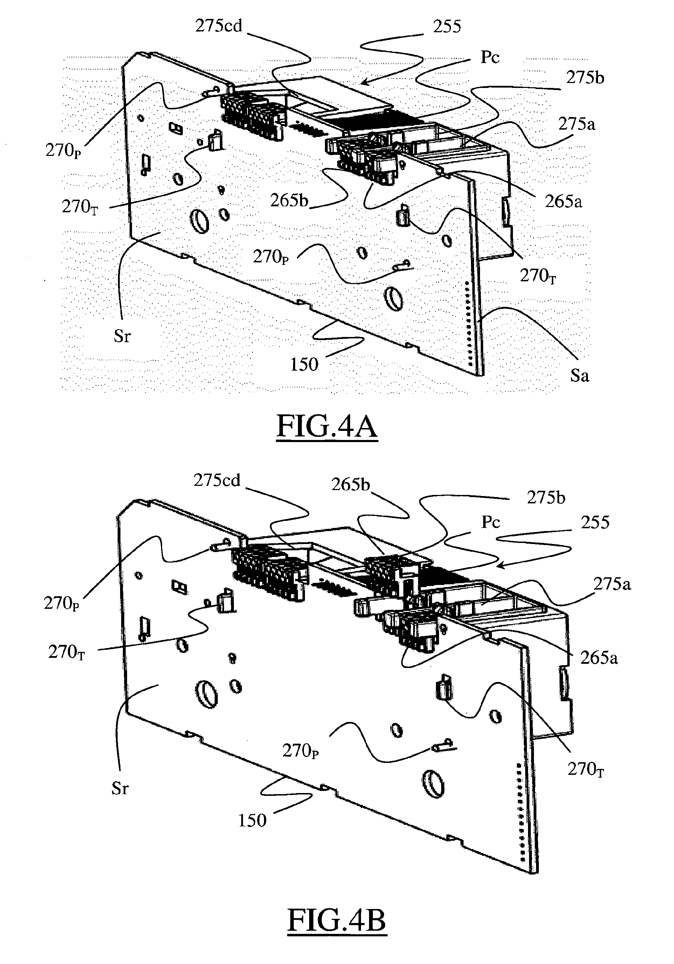

Referring now to **Figure 2****,** it shows a perspective exploded view of a control-panel assembly (denoted as a whole by the number reference **245**) according to an embodiment of the present invention; for the sake of conciseness and clarity, such figure will be discussed together with **Figures 3A** and **3B****,** which schematically show perspective front views of a part of the control-panel assembly according to an assembled configuration and to a partly-assembled configuration, respectively, and with **Figures 4A** and **4B****,** the latter showing perspective rear views of the same part of the control-panel assembly of **Figures 3A** and **3B****,** respectively.

As visible in such figures, the control-panel assembly **245** comprises a printed circuit board (or PCB) **250** for electrically connecting, on a corresponding active surface **Sa** thereof (*e.g*., the one facing the shell **125,** as illustrated in the figure) the rotatable knob, the buttons (both of them not shown in such figures), and a display assembly **255.** As visible in the figures, the display assembly **255** comprises the display device **140,** the latter being preferably associated with a mounting member **260** and connection leads (*e.g*., pins, denoted as whole by the reference **Pc**) for removably mounting and electrically connecting, respectively, the display device **140** on the PCB **250.**

Moreover, as usual, the PCB **250** electrically connects functional components (*e.g*., electronic circuitry components, not visible) for implementing corresponding control functionalities of the control-panel assembly **245** (*e.g*. powering, driving, activation, deactivation of one or more operative loads including electric, electronic, electro-mechanical and/or electro-hydraulic parts of the appliance - such as motor, solenoid valve, further PCBs, not shown). In this respect, the PCB **250** comprises one ore more (*e.g*. four, as depicted in the figures) electrical connectors (in the following, connectors) **265a, 265b, 265c, 265d** apt to be fixed to a corresponding terminal region of the PCB **250** (*i.e*., the region on the active surface **Sa** of the PCB **250 -** not visible - comprising contactable terminals of the functional components) for allowing connection thereof to one or more operative loads of the appliance.

Preferably, as best visible in **Figures 4A** and **4B****,** at least part of the connectors **265a, 265b, 265c, 265d** (all, in the disclosed embodiment) are of the straddle-mounting type, *i.e.* are configured for contacting corresponding terminals of the terminal region by straddling, thus holding to, opposite surfaces of the PCB **250.** In the illustrated example, each straddle-mounting connector **265a,265b,265c,265d** is configured for being mounted straddle the active surface **Sa** of the PCB **250** and a rear surface **Sr** thereof opposite the active surface **Sa.** Moreover, by way of example only, some of the connectors **265a, 265b, 265c, 265d,** *e.g*. the connectors **265c** and **265d,** are assumed to be hard-mounted (*i.e*., fixedly, irreversibly mounted on the PCB **250,** *e.g.* by gluing or soldering, before assembling of the display assembly **255**), as typically all the connectors of a PCB are, whereas the remaining connectors, *i.e.* the connectors **265a, 265b** are assumed to be fixed to the respective contact regions after mounting of the display assembly on the PCB **250** (hereinafter also referred to as movable connectors).

According to the general principles of the present invention, the mounting member **260** (preferably, although not necessarily, made of plastic material) is configured for holding the display device **140** and allowing mounting of the display assembly **255** on the active surface **Sa** of the PCB **250,** and is designed such as to comprise recessed portions mainly conceived for exposing the terminal region and allowing reversible fixing thereon of the (movable) connectors **265a, 265b** and hence connection to one or more operative loads of the appliance.

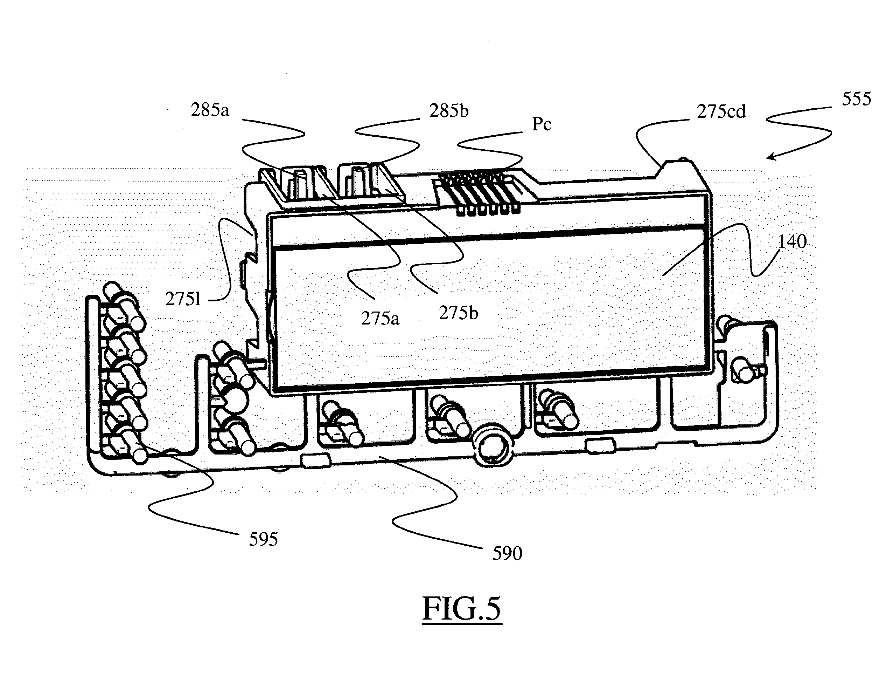

According to a preferred embodiment of the present invention, the mounting member **260** comprises a *e.g*. substantially hollow parallelepiped-shaped support body **260s** (only visible in **Figure 2**) for generally supporting the display device **140** and maintaining the latter at a proper distance from the PCB **250** (*i.e*., equivalently, maintaining the PCB **250** at a proper distance from the shell **125** when the control-panel assembly **245** is assembled); advantageously, a front edge portion (not visible in the figure) of the support body **260s** is configured with a seat (best visible in **Figure 5****,** discussed below) provided for being fixed (*e.g*., by engaging, clipping, snapping, gluing, screwing and/or any other fixing technique) to the display device **140,** whereas a rear edge portion opposite to the front edge portion (visible in **Figure 2**) is configured for abutting on the active surface **Sa** of the PCB **250** in the assembled configuration of the display assembly **255.** In this way, in the assembled configuration, the display assembly **255** advantageously covers at least part of the active surface **Sa** for mechanical protection thereof.

The mounting member **260** further comprises, monolithic (*e.g*. moulded together) with the support body **260s,** a *e.g*. frame body **260f** substantially surrounding at least part of (in the considered example, all) the lateral surface of the support body **260s** for allowing the display assembly **255** to be effectively mounted on the active surface **Sa** of the PCB **250.** In this respect, the frame body **260f** is preferably provided, as best visible in **Figures 4A** and **4B****,** with one or more (*e.g*., four) insertion elements (*e.g*. tongues and/or pins, such as the depicted two tongues **270_{T}** and two pins **270_{P}),** protruding beyond the rear edge portion of the support body **260s** and configured for being inserted into corresponding through-holes of the PCB **250** (for mounting of the display assembly **255**). Thus, when mounting the display assembly **255**, the tongues **270_{T}** and the pins **270_{P},** after insertion into the through-holes, protrudes from the rear surface of the PCB **250,** and then can be fixed by any known fixing technique (*e.g*., snap-fitting, as herein assumed and briefly discussed below, or gluing, screwing, and the like) in order to ensure stability to the mounting. As should be readily understood, arrangement of the insertion elements **270_{T}, 270p** is not limiting for the present invention, as it can be chosen according to specific design parameters (*e.g*. for ensuring improved stability of the display assembly **255** on the PCB **250**). In the not limiting disclosed embodiment, the insertion elements **270_{T}, 270_{P}** are symmetrically arranged on the frame body **260f**, *e.g*. with the tongues **270_{T}** that are substantially centrally arranged with respect to a height of the display assembly **255**, and the pins **270_{P}** that are at the opposite uppermost and lowermost "vertexes" of the display assembly **255** (see **Figures 4A** and **4B**).

As visible in the figures, the frame body **260f** comprises, at one or more surfaces thereof, the above-mentioned recessed portions (*e.g*. seven, all generally denoted by the reference **275** and functionally diversified by respective subscripts); according to the specific configuration to be implemented, such recessed portions may designed for delimiting the connectors **265a, 265b, 265c, 265d,** thereby preventing them from coming into contact with the frame body **260f**, and/or for retaining the connectors **265a, 265b, 265c, 265d,** thereby preventing accidental extraction thereof from the PCB **250,** and/or for providing the frame body **260f** with desired mechanical features.

For example, a delimiting recessed portion **275cd** (on the upper surface of the frame body **260f**) is configured for exposing the hard-mounted connectors **265c** and **265d** thereby preventing them from coming into contact with the frame body **260f** as well as making them accessible for proper connection and disconnection to operative loads of the appliance, side recessed portions **2751** (*e.g*., four, two for each side surface of the frame body **260f**) are configured for providing the frame body **260f** with a predefined degree of elastic deformability (*e.g*., for allowing insertion of the insertion elements **270_{T},270_{P}** into the corresponding through-hole of the PCB **250** upon exertion of a compression force on the frame body **260f,** and snap-fit engagement between the insertion elements **270_{T},270_{P}** and the corresponding through-hole upon inexertion of said compression force), whereas retaining recessed portions **275a** and **275b** (on the upper surface of the frame body **260f** too) are configured for delimiting the connectors **265a** and **265b** thereby preventing them from coming into contact with the frame body **260f** as well as providing the connectors **265a** and **265b** with firm fixing/holding and improved accessibility ease (*e.g*., with respect to the delimiting recessed portion **275cd**) for proper connection and disconnection thereof.

Preferably, as illustrated in the figures, each retaining recessed portion **275a, 275b** is provided with a corresponding (*e.g*. U-shaped) guiding member **280a, 280b** substantially acting as inner wall of the retaining recessed portion **275a, 275b** for guiding the connector **265a, 265b** to the terminal region of the PCB **250;** in this respect, as can be best appreciated in **Figures 4A** and **4B****,** the guiding member **280a, 280b** has a width substantially matching the width of the connector **265a, 265b** and protrudes, after mounting of the display assembly **255** on the PCB **250,** beyond the rear surface **Sr** of the PCB **250** for guiding the connector **265a, 265b** both at the active surface side and at the rear surface side thereof.

Preferably, as can be best appreciated in **Figures 3A** and **3B****,** each retaining recessed portion **275a, 275b** is further provided with a *e.g*. plastic clip element **285a, 285b** mechanically connected to (*e.g*. molded together with) the guiding member **280a, 280b,** and configured for snap-fitting the connector **265a, 265b** on the PCB **250.**

As should be readily understood, the concurrent provisions of a mounting member holding the display **140** and directly mounted only on the active surface **Sa** of the PCB **250** (instead of completely enclosing it, as in most of the known solutions) and of the recessed portions, allows the connectors **265a,265b,265c,265d** to be easily, effectively, reliably accessible for connection to one or more operative loads of the appliance (*e.g*. by connection elements such as electric wires, pins and the like). Moreover, the snap-fit mechanism of the retaining recessed portions **275a,275b** allows the (movable) connectors **265a,265b** to be easily, effectively, reliably accessible for being easily reversible fixed to the terminal region of the PCB **250,** without using techniques that could make the fixing/holding subject to corrosions and other wearing effects over time.

With reference now to **Figure 5****,** it shows a front view of a display assembly **555** according to another embodiment of the present invention. The display assembly **555** is similar to the display assembly of the previous embodiment, *i.e*. comprises the mounting member **260** and the display **140,** but with respect to the latter further comprises a supporting rack **590** having one or more lighting guides **595** that face corresponding lighting members (*e.g*. LED devices, not shown, provided for lighting the rotatable knob, the buttons and the like, and/or acting as warning or status lights during operation of the appliance) arranged on the on the active surface **Sa** of the PCB **250** when the display assembly **555** is mounted onto the PCB **250.** The outer portions of the lighting guides **595** are received in corresponding apertures or seats or light permeable portions formed in the front part of basin-shaped rigid shell **125** of dashboard **120** so as to make the light produced by the lighting members visible to a user resting in front of the appliance.

The supporting rack **590,** preferably made of a plastic material comprising at least a portion suitable to be permeated by light, *e.g*. the same as the mounting member **260,** can be advantageously obtained monolithically (*e.g*. molded together) with the mounting member **260.** Alternatively, the supporting rack **590** and the mounting member **260** may be made of different plastic materials wherein one or both of such materials comprise at least a light permeable portion. Anyway, shape of the supporting rack **590,** as well as shape, number and types of the lighting guides **595** illustrated and described have not to be construed limitatively, since many implementations, all falling within the above principles of the present invention, are possible.

Naturally, in order to satisfy local and specific requirements, a person skilled in the art may apply to the solution described above many logical and/or physical modifications and alterations. More specifically, although the present invention has been described with a certain degree of particularity with reference to preferred embodiments thereof, it should be understood that various omissions, substitutions and changes in the form and details as well as other embodiments are possible. In particular, different embodiments of the invention may even be practiced without the specific details (such as the numeric examples) set forth in the preceding description for providing a more thorough understanding thereof; on the contrary, well known features may have been omitted or simplified in order not to obscure the description with unnecessary particulars. Moreover, it is expressly intended that specific elements and/or method steps described in connection with any disclosed embodiment of the invention may be incorporated in any other embodiment as a matter of general design choice.

For example, analogous considerations apply if the appliance has a different structure or includes equivalent components, or it has other operating features. In any case, any component thereof may be separated into several elements, or two or more components may be combined into a single element; in addition, each component may be replicated for supporting the execution of the corresponding operations in parallel. It should also be noted that any interaction between different components generally does not need to be continuous (unless otherwise indicated), and it may be both direct and indirect through one or more intermediaries.

## Claims

1. Electric appliance (**100**) for items treatment comprising a control-panel assembly (**245**) for controlling operation of the electric appliance (**100**) and ascertaining an operational state thereof, the control-panel assembly (**245**) comprising
a display assembly (**255,555**) having a display device (**140**), and
a printed circuit board (**250**) having
an active surface (**Sa**) for mechanically supporting and electrically connecting the display device (**140**), and
at least one electrical connector (**265a,265b,265c,265d**) apt to be fixed to a corresponding terminal region of the printed circuit board (**250**) for allowing connection thereof to one or more operative loads of the electric appliance (**100**),
**characterized in that**
the display assembly (**255,555**) comprises a mounting member (**260**) for holding the display device (**140**) and allowing mounting of the display assembly (**255,555**) on the active surface (**Sa**) of the printed circuit board (**250**), the mounting member (**260**) comprising at least one recessed portion (**275a,275b**) for exposing the terminal region thereby allowing reversible fixing thereon of the at least one electrical connector (**265a,265b,265c,265d**) and hence connection to one or more operative loads of the appliance.

2. The electric appliance (**100**) according to Claim 1, wherein circuitry for performing functionalities of the control-panel assembly (**245**) is provided on the active surface (**Sa**), and wherein the mounting member (**260**) comprises
a substantially hollow parallelepiped-shaped support body (**260s**) having a first edge portion fixed to the display device (**140**) for supporting it, and a second edge portion opposite the first edge portion for abutting on the active surface (**Sa**) upon mounting of the display assembly (**255,555**) thereon, the display assembly (**255,555**) covering at least part of the circuitry for mechanical protection thereof, and
a frame body (**260f**) substantially surrounding at least part of the support body (**260s**), the frame body (**260f**) being provided with the at least one recessed portion (**275a,275b**).

3. The electric appliance (**100**) according to Claim 2, wherein the at least one electrical connector (**265a,265b,265c,265d**) comprises at least one straddle-mounting connector (**265a,265b,265c,265d**), and wherein the at least one recessed portion (**275a,275b**) comprises
a guiding member (**280a,280b**) for guiding the at least one straddle-mounting connector (**265a,265b,265c,265d**) to the terminal region of the printed circuit board (**250**), and
a clip element (**285a,285b**) mechanically connected to the guiding member (**280a,280b**) and configured for snap-fitting the at least one straddle-mounting connector (**265a,265b,265c,265d**) to the terminal region thereby enabling electrical connection thereof.

4. The electric appliance (**100**) according to Claim 3, wherein the at least one straddle-mounting connector (**265a,265b,265c,265d**) is configured for being mounted straddle the active surface (**Sa**) and a rear surface (**Sr**) of the printed circuit board (**250**) opposite the active surface (**Sa**), and wherein the guiding member (**280a,280b**) is substantially U-shaped with a width substantially matching the width of the at least one straddle-mounting connector (**265a,265b,265c,265d**), and protrudes, after mounting of the display assembly (**255,555**), beyond the rear surface (**Sr**) of the printed circuit board (**250**) for guiding the at least one straddle-mounting connector (**265a,265b,265c,265d**) both at the active surface side and at the rear surface side thereof.

5. The electric appliance (**100**) according to any of the preceding Claims, wherein the frame body (**260f**) is further provided with at least one further recessed portion (**275cd**) for exposing at least one of the at least one electrical connector (**265a,265b,265c,265d**) hard-mounted on the printed circuit board (**250**) thereby allowing connection thereof to one or more operative loads of the appliance.

6. The electric appliance (**100**) according to any Claim from 2 to 5, wherein the frame body (**260f**) comprises at least one insertion element (**270_{T},270_{P}**) protruding beyond the rear edge portion of the support body (**260s**), and configured for being inserted into corresponding through-holes of the printed circuit board (**250**) for mounting of the display assembly (**255,555**).

7. The electric appliance (**100**) according to Claim 6, wherein the frame body (**260f**) further comprises at least one still further recessed portion (**2751**) configured for providing the frame body (**260f**) with a predefined degree of elastic deformability that allows insertion of the at least one insertion element (**270_{T},270_{P}**) into the corresponding through-hole of the printed circuit board (**250**) upon exertion of a compression force on the frame body (**260f**), and snap-fit engagement between the at least one insertion element (**270_{T},270_{P}**) and the corresponding through-hole upon inexertion of said compression force.

8. The electric appliance (**100**) according to any of the preceding Claims, wherein the display assembly (**555**) further comprises at least one lighting guide (**595**) configured for conveying light produced by one or more lighting members arranged on the active surface (**Sa**) of printed circuit board (**250**), and a supporting rack (**590**) mechanically connected to the mounting member (**260**) for supporting the at least one lighting guide (**595**).

9. The electric appliance (**100**) according to Claim 8, wherein the supporting rack (**590**) and/or the mounting member (**260**) are made of plastic material.

10. The electric appliance (**100**) according to Claim 9, wherein said plastic material comprises at least a light permeable portion.

11. The electric appliance (**100**) according to any Claim 8 to 10, wherein the at least one lighting guide faces said one or more lighting members when the display assembly (**555**) is mounted onto the printed circuit board (**250**).

12. The electric appliance (**100**) according to any of the preceding Claims, further comprising a manually-operable dashboard (**120**), the dashboard (**120**) representing an exposed part of the control-panel assembly (**245**) and comprising
a substantially basin-shaped rigid shell (**125**) and
at least one manually-operable control member (**130,135,140**) engaging corresponding pass-through openings and/or seats of the shell (**125**) and electrically connected to the printed circuit board (**250**).

13. The electric appliance (**100**) according to Claim 12, wherein the at least one control member comprises at least one rotatable knob (**130**), at least one button (**135**), and/or the display device (**140**).

14. The electric appliance (**100**) according to any of the preceding Claims, wherein the electric appliance (**100**) comprises one among front or top loading washing machine, washer/dryer, dryer, dishwasher, refrigerator, oven.

## Patentansprüche

1. Elektrogerät (100) für die Behandlung von Gegenständen, die eine Bedienfeldbaueinheit (245) zum Steuern des Betriebs des Elektrogeräts (100) und Feststellen eines Betriebszustandes desselben aufweist, wobei die Bedienfeldbaueinheit (245) aufweist
eine Anzeigebaueinheit (255, 555) mit einer Anzeigeeinrichtung (140) und
eine gedruckte Leiterplatte (250) mit
einer aktiven Fläche (Sa) zum mechanischen Abstützen und elektrischen Verbinden der Anzeigeeinrichtung (140) und
mindestens einem elektrischen Verbindungselement (265a, 265b, 265c, 265d), das dazu geeignet ist, an einem entsprechenden Anschlussbereich der gedruckten Leiterplatte (250) befestigt zu werden, um dessen Verbindung mit einer oder mehreren Betriebslasten des Elektrogeräts (100) zu ermöglichen,
**dadurch gekennzeichnet, dass**
die Anzeigebaueinheit (255, 555) ein Montageelement (260) zum Halten der Anzeigeeinrichtung (140) und Ermöglichen der Montage der Anzeigebaueinheit (255, 555) an der aktiven Fläche (Sa) der gedruckten Leiterplatte (250) aufweist, wobei das Montageelement (260) mindestens einen zurückgesetzten Teil (275a, 275b) zum Freilegen des Anschlussbereichs aufweist, wodurch eine reversible Befestigung des mindestens einen elektrischen Verbindungselements (265a, 265b, 265c, 265d) daran und daher eine Verbindung mit einer oder mehreren Betriebslasten des Geräts ermöglicht ist.

2. Das Elektrogerät (100) nach Anspruch 1, wobei eine Schaltungsanordnung zum Durchführen von Funktionalitäten der Bedienfeldbaueinheit (245) an der aktiven Fläche (Sa) vorgesehen ist, und wobei das Montageelement (260) aufweist
einen im Wesentlichen hohlen, parallelepipedförmigen Stützkörper (260s) mit einem ersten Kantenteil, der an der Anzeigevorrichtung (140) befestigt ist, um sie abzustützen, und einem zweiten Kantenteil entgegengesetzt zum ersten Kantenteil zum Anliegen an der aktiven Fläche (Sa) bei der Montage der Anzeigebaueinheit (255, 555) an dieser, wobei die Anzeigebaueinheit (255, 555) zumindest einen Teil der Schaltungsanordnung für deren mechanischen Schutz bedeckt, und
einen Rahmenkörper (260f), der zumindest einen Teil des Stützkörpers (260s) im Wesentlichen umgibt, wobei der Rahmenkörper (260f) mit dem mindestens einen zurückgesetzten Teil (275a, 275b) versehen ist.

3. Das Elektrogerät (100) nach Anspruch 2, wobei das mindestens eine elektrische Verbindungselement (265a, 265b, 265c, 265d) mindestens ein Spreizmontage-Verbindungselement (265a, 265b, 265c, 265d) aufweist und wobei der mindestens eine zurückgesetzte Teil (275a, 275b) aufweist
ein Führungselement (280a, 280b) zum Führen des mindestens einen Spreizmontage-Verbindungselements (265a, 265b, 265c, 265d) zum Anschlussbereich der gedruckten Leiterplatte (250) und
ein Klemmelement (285a, 285b), das mit dem Führungselement (280a, 280b) mechanisch verbunden ist und zum Einrasten des mindestens einen Spreizmontage-Verbindungselements (265a, 265b, 265c, 265d) am Anschlussbereich ausgelegt ist, wodurch eine elektrische Verbindung davon ermöglicht ist.

4. Das Elektrogerät (100) nach Anspruch 3, wobei das mindestens eine Spreizmontage-Verbindungselement (265a, 265b, 265c, 265d) zur Spreizmontage an der aktiven Fläche (Sa) und einer hinteren Fläche (Sr) der gedruckten Leiterplatte (250) entgegengesetzt zur aktiven Fläche (Sa) ausgelegt ist, und wobei das Führungselement (280a, 280b) im Wesentlichen U-förmig mit einer Breite ist, die im Wesentlichen der Breite des mindestens einen Spreizmontage-Verbindungselements (265a, 265b, 265c, 265d) entspricht, und nach dem Montieren der Anzeigebaueinheit (255, 555) über die hintere Fläche (Sr) der gedruckten Leiterplatte (250) hinaus vorsteht, zum Führen des mindestens einen Spreizmontage-Verbindungselements (265a, 265b, 265c, 265d) sowohl auf der Seite der aktiven Fläche als auch der Seite der hinteren Fläche derselben.

5. Das Elektrogerät (100) nach einem der vorangehenden Ansprüche, wobei der Rahmenkörper (260f) ferner mit mindestens einem weiteren zurückgesetzten Teil (275cd) zum Freilegen von mindestens einem des mindestens einen elektrischen Verbindungselements (265a, 265b, 265c, 265d) versehen ist, das an der gedruckten Leiterplatte (250) fest montiert ist, wodurch eine Verbindung davon mit einer oder mehreren Betriebslasten des Geräts ermöglicht ist.

6. Das Elektrogerät (100) nach einem Anspruch von 2 bis 5, wobei der Rahmenkörper (260f) mindestens ein Einsetzelement (270_{T}, 270_{P}) aufweist, das über den hinteren Kantenteil des Stützkörpers (260s) hinaus vorsteht und zum Einsetzen in entsprechende Durchgangslöcher der gedruckten Leiterplatte (250) zum Montieren der Anzeigebaueinheit (255, 555) ausgelegt ist.

7. Das Elektrogerät (100) nach Anspruch 6, wobei der Rahmenkörper (260f) ferner mindestens einen noch weiteren zurückgesetzten Teil (275I) aufweist, der zum Versehen des Rahmenkörpers (260f) mit einem vordefinierten Grad an elastischer Verformbarkeit ausgelegt ist, was das Einsetzen des mindestens einen Einsetzelements (270_{T}, 270_{P}) in das entsprechende Durchgangsloch der gedruckten Leiterplatte (250) beim Ausüben einer Druckkraft auf den Rahmenkörper (260f) und einen Schnappsitzeingriff zwischen dem mindestens einen Einsetzelement (270_{T}, 270_{P}) und dem entsprechenden Durchgangsloch beim Aufheben der Druckkraft ermöglicht.

8. Das Elektrogerät (100) nach einem der vorangehenden Ansprüche, wobei die Anzeigebaueinheit (555) ferner mindestens einen Lichtleiter (595), der zum Befördern von Licht ausgelegt ist, das durch ein oder mehrere Beleuchtungselemente erzeugt wird, die auf der aktiven Fläche (Sa) der gedruckten Leiterplatte (250) angeordnet sind, und ein mit dem Montageelement (260) mechanisch verbundenes Stützgestell (590) zum Abstützen des mindestens einen Lichtleiters (595) aufweist.

9. Das Elektrogerät (100) nach Anspruch 8, wobei das Stützgestell (590) und/oder das Montageelement (260) aus einem Kunststoffmaterial bestehen.

10. Das Elektrogerät (100) nach Anspruch 9, wobei das Kunststoffmaterial mindestens einen lichtdurchlässigen Teil aufweist.

11. Das Elektrogerät (100) nach einem Anspruch 8 bis 10, wobei der mindestens eine Lichtleiter dem einen oder den mehreren Beleuchtungselementen zugewandt ist, wenn die Anzeigebaueinheit (555) an der gedruckten Leiterplatte (250) montiert ist.

12. Das Elektrogerät (100) nach einem der vorangehenden Ansprüche, das ferner ein manuell bedienbares Armaturenbrett (120) aufweist, wobei das Armaturentafel (120) einen freigelegten Teil der Bedienfeldbaueinheit (245) darstellt und aufweist
eine im Wesentlichen beckenförmige starre Hülle (125) und
mindestens ein manuell bedienbares Steuerelement (130, 135, 140), das mit entsprechenden Durchgangsöffnungen und/oder Sitzen der Hülle (125) in Eingriff steht und mit der gedruckten Leiterplatte (250) elektrisch verbunden ist.

13. Das Elektrogerät (100) nach Anspruch 12, wobei das mindestens eine Steuerelement mindestens einen drehbaren Knopf (130), mindestens eine Taste (135) und/oder die Anzeigeeinrichtung (140) aufweist.

14. Das Elektrogerät (100) nach einem der vorangehenden Ansprüche, wobei das Elektrogerät (100) eines aufweist aus eine Front- oder Toplader-Waschmaschine, einen Waschtrockner, einen Trockner, eine Geschirrspülmaschine, einen Kühlschrank, einen Ofen.

## Revendications

1. Appareil électrique (100) destiné à traiter des articles comprenant un ensemble de panneau de commande (245) destiné à commander le fonctionnement de l'appareil électrique (100) et à vérifier un état de fonctionnement de celui-ci, l'ensemble de panneau de commande (245) comprenant
un ensemble d'affichage (255, 555) ayant un dispositif d'affichage (140), et
une carte de circuit imprimé (250) ayant
une surface active (Sa) destinée à supporter mécaniquement et à connecter électriquement le dispositif d'affichage (140), et
au moins un connecteur électrique (265a, 265b, 265c, 265d) ayant être fixé à une région de borne correspondante de la carte de circuit imprimé (250) pour permettre une connexion de celui-ci à une ou plusieurs charges opérationnelles de l'appareil électrique (100),
**caractérisé en ce que**
l'ensemble d'affichage (255, 555) comprend un organe de montage (260) destiné à maintenir le dispositif d'affichage (140) et à permettre le montage de l'ensemble d'affichage (255, 555) sur la surface active (Sa) de la carte de circuit imprimé (250), l'organe de montage (260) comprenant au moins une portion évidée (275a, 275b) destinée à exposer la région de borne, permettant ainsi une fixation réversible sur celle-ci du au moins un connecteur électrique (265a, 265b, 265c, 265d) et ainsi la connexion à une ou plusieurs charges opérationnelles de l'appareil.

2. Appareil électrique (100) selon la revendication 1, dans lequel la circuiterie destinée à réaliser les fonctionnalités de l'ensemble de panneau de commande (245) est disposée sur la surface active (Sa), et dans lequel l'organe de montage (260) comprend
un corps de support en forme de parallélépipède sensiblement creux (260s) ayant une première portion de bord fixée au dispositif d'affichage (140) afin de le supporter, et une seconde portion de bord opposée à la première portion de bord afin de buter contre la surface active (Sa) lors du montage de l'ensemble d'affichage (255, 555) sur celle-ci, l'ensemble d'affichage (255, 555) couvrant au moins une partie de la circuiterie pour une protection mécanique de celle-ci, et
un corps de châssis (260f) entourant sensiblement au moins une partie du corps de support (260s), le corps de châssis (260f) étant doté de la au moins une portion évidée (275a, 275b).

3. Appareil électrique (100) selon la revendication 2, dans lequel le au moins un connecteur électrique (265a, 265b, 265c, 265d) comprend au moins un connecteur à montage chevauchant (265a, 265b, 265c, 265d) et dans lequel la au moins une portion évidée (275a, 275b) comprend
un organe de guidage (280a, 280b) destiné à guider le au moins un connecteur à montage chevauchant (265a, 265b, 265c, 265d) vers la région de borne de la carte de circuit imprimé (250), et
un élément d'attache (285a, 285b) raccordé mécaniquement à l'organe de guidage (280a, 280b) et configuré pour l'encliquetage du au moins un connecteur à montage chevauchant (265a, 265b, 265c, 265d) avec la région de borne, permettant ainsi une connexion électrique de celui-ci.

4. Appareil électrique (100) selon la revendication 3, dans lequel le au moins un connecteur à montage chevauchant (265a, 265b, 265c, 265d) est configuré pour être monté chevauchant sur la surface active (Sa) et une surface arrière (Sr) de la carte de circuit imprimé (250) opposée à la surface active (Sa), et dans lequel l'organe de guidage (280a, 280b) est sensiblement en forme de U avec une largeur correspondant sensiblement à la largeur du au moins un connecteur à montage chevauchant (265a, 265b, 265c, 265d), et fait saillie, après montage de l'ensemble d'affichage (255, 555) au-delà de la surface arrière (Sr) de la carte de circuit imprimé (250) destinée guider le au moins un connecteur à montage chevauchant 265b, 265c, 265d) à la fois du côté surface active et du côté surface arrière de celui-ci.

5. Appareil électrique (100) selon l'une quelconque des revendications précédentes, dans lequel le corps de châssis (260f) est en outre doté d'au moins une portion évidée supplémentaire (275cd) destinée à exposer au moins l'un des au moins un connecteur électrique (265a, 265b, 265c, 265d) monté de façon rigide sur la carte de circuit imprimé (250), permettant ainsi la connexion de celle-ci à une ou plusieurs charges opérationnelles de l'appareil.

6. Appareil électrique (100) selon l'une quelconque des revendications 2 à 5, dans lequel le corps de châssis (260f) comprend au moins un élément d'insertion (271_{T}, 270_{P}) faisant saillie au-delà de la portion de bord arrière du corps de support (260s), et configuré pour être inséré dans des trous traversants correspondants de la carte de circuit imprimé (250) pour le montage de l'ensemble d'affichage (255, 555).

7. Appareil électrique (100) selon la revendication 6, dans lequel le corps de châssis (260f) comprend en outre au moins encore une portion évidée supplémentaire (2751) configurée pour doter le corps de châssis (260f) d'un degré prédéfini de déformabilité élastique qui permet l'insertion du au moins un élément d'insertion (270_{T,} 270_{P}) dans le trou traversant correspondant de la carte de circuit imprimé (250) lorsqu'une force de compression est exercée sur le corps de châssis (260f), et l'enclenchement par encliquetage entre le au moins un élément d'insertion (270_{T}, 270_{P}) et le trou traversant correspondant lors de la non-exécution de ladite force de compression.

8. Appareil électrique (100) selon l'une quelconque des revendications précédentes, dans lequel l'ensemble d'affichage (555) comprend en outre au moins un guide d'éclairage (595) configuré pour acheminer la lumière produite par un ou plusieurs organes d'éclairage agencés sur la surface active (Sa) de la carte de circuit imprimé (250), et un bâti de support (590) raccordé mécaniquement à l'organe de montage (260) destiné à supporter le au moins un guide d'éclairage (595).

9. Appareil électrique (100) selon la revendication 8, dans lequel le bâti de support (590) et/ou l'organe de montage (260) sont constitués d'un matériau plastique.

10. Appareil électrique (100) selon la revendication 9, dans lequel ledit matériau plastique comprend au moins une portion perméable à la lumière.

11. Appareil électrique (100) selon l'une quelconque des revendications 8 à 10, dans lequel le au moins un guide d'éclairage fait face auxdits un ou plusieurs organes d'éclairage lorsque l'ensemble d'affichage (555) est monté sur la carte de circuit imprimé (250).

12. Appareil électrique (100) selon l'une quelconque des revendications précédentes, comprenant en outre un tableau de bord actionné manuellement (120), le tableau de bord (120) représentant une partie exposée de l'ensemble de panneau de commande (245) et comprenant
une coque rigide sensiblement en forme de cuvette (125) et
au moins un organe de commande actionné manuellement (130, 135, 140) enclenchant des ouvertures de passage et/ou sièges correspondants de la coque (125) et électriquement connecté à la carte de circuit imprimé (250).

13. Appareil électrique (100) selon la revendication 12, dans lequel le au moins un organe de commande comprend au moins un bouton rotatif (130), au moins une touche (135) et/ou le dispositif d'affichage (140).

14. Appareil électrique (100) selon l'une quelconque des revendications précédentes, dans lequel l'appareil électrique (100) comprend au moins l'un d'une machine à laver à chargement frontal ou par le dessus, une machine à laver/séchante, un sèche-linge, un lave-vaisselle, un réfrigérateur, un four.
